# EUROPEAN PATENT APPLICATION

(11) **EP 3 364 196 A1**
(43) Date of publication of application: **22.08.2018**
(21) Application number: 17382084.6
(22) Date of filing: 20.02.2017
(51) Int. Cl.: G01R 15/14

(54) **HIGH VOLTAGE MEASURING PLUG DEVICE**

(71) Applicant: Arteche Centro de Tecnologia, A.I.E., 48100 Munguia (Vizcaya) (ES)
(72) Inventor: GARABIETA, Iñaki, 48100 Mungia, Vizcaya (ES)
(74) Representative: Balder IP Law, S.L.

(57) **Abstract**

The high voltage plug device (1) comprises a body (2) and a voltage sensor (3). The body (2) comprises a first closed end (21) comprising a low voltage terminal (211), and a second open end (22) comprising a housing (23) to receive a rigid bushing (4) of a high voltage equipment (41). The second open end (22) comprises a high voltage terminal (222). The voltage sensor (3) is embedded along the body (2) between the first closed end (21) and second open end (22) of the body (2) such that a first terminal (31) of the sensor (3) is connected to the low voltage terminal (211) and a second terminal (32) of the sensor (3) is connected to the high voltage terminal (222). The body (2) comprises a flexible material such that, when the plug (1) is coupled to the bushing (4), the body (2) deforms to fit to the bushing (4) in an airtight sealing connection and the high voltage terminal (222) of the body (2) contacts with an electrical terminal (42) of the bushing (4) to measure a voltage magnitude of a device of the high voltage equipment connected to the bushing (4).

## Description

### FIELD OF THE INVENTION

The invention is encompassed in the field of high voltage elements configured to be connected to high voltage cells and especially high voltage measuring devices.

### BACKGROUND OF THE INVENTION

Apparatus for measuring the voltage of high voltage equipment in high voltage cells are known. Some of these apparatus comprise sensors embedded in a rigid cone made of resin which is configured as a male plug which can be connected to a T-shaped silicon connector which, in turn, is connected to a bushing or rigid base of the high voltage cell. The bushing is usually a male-shaped bushing made of resin (standard DIN connectors as CENELEC EN 50180/50181) and the T-shaped connector comprise a vertical branch for the connection of a high voltage cable, and two horizontal branches with open ends (in a female configuration), one end to be coupled to the standard DIN bushing (in a male configuration) of a first the high voltage cell and the other end is left unused or can be connected to a second HV cell to interconnect the first and second cell.

Consequently, the rigid resin plug with the voltage sensor can only be coupled to the HV cell if there is already a T-shaped connector coupled to the high voltage cell and the T-shaped connector has an available port where the male plug with the voltage sensor can be connected to.

EP-2605416B1 discloses one of such male plugs. EP-2605416B1 discloses an electric DIN C coupler (made of resin) for the connection, through a T-shaped connector, to a high voltage cell. This coupler comprises a resin body and a voltage divider, a condenser and two terminal contacts and wherein the condenser is elongated and its ends are in contact with the two terminals of the coupling device, occupying an axis parallel to the imaginary central axis of the connector passing through the two contacts and wherein the resistances of the divider are aligned and parallel to the mentioned axis of the zigzag device.

EP-1391740B1 also discloses a resin conical male plug with a voltage sensor connectable to a female port in a T-shape silicon connector previously coupled to a DIN shaped bushing of a high voltage cell. EP-1391740B1 discloses a system to provide connection of a cable to a HV equipment with a high level of protection, simultaneously providing the current and voltage values at the corresponding connection point. It is basically comprised of a toroidal inductive element, mounted around the bushing, for measuring the current and a resistive element, integrated in a separable male plug connected to the a free port of the T shaped connector, for measuring the voltage

Another different solution is described in EP-2518843B1. This document describes a HV connection device comprising three insulating bodies, one T shaped body for the connection to a first electrical equipment, one elbow body for the connection to a second electrical equipment and a cylindrical body for the interconnection of the first and second body. The voltage sensor being placed in rigid male plugs connectable in the free ports of the T shaped and elbow shaped bodies.

Alternative solutions to reduce the number of parts used to measure the voltage of the high voltage equipment inside the cell are T-shaped or L-shaped (elbow-shaped) silicon connectors that include embedded sensors. EP-2658044A1 discloses one of these connectors having embedded sensors. EP-2658044A1 discloses a high voltage connector comprising an insulating silicon body with a first internal channel for housing a HV cable and a second internal channel, configured to receive a rigid resin bushing of a high voltage equipment. The connector comprises at least one sensor of an electric magnitude at least partially embedded inside the insulating body.

In sum, with the solutions provided in the art, when there is the need to measure the voltage of any device of the high voltage cell, it is always compulsory to use an intermediate silicon connector (with a high voltage cable) connected to the bushing or fixed base of the high voltage cell. The problem is that when there is no need to connect a high voltage cable to the cells no such connector is provided and consequently it is not possible to measure the voltage of the high voltage equipment inside the cell.

### DESCRIPTION OF THE INVENTION

To solve the aforementioned technical problems the present invention refers to a high voltage plug device comprising a body and a voltage sensor. The body comprises a first closed end comprising a low voltage terminal, and a second open end comprising a housing to receive a rigid bushing or fixed base (made of resin) of a high voltage equipment. The first open end comprises a high voltage terminal (the high voltage terminal being accessible through the housing). The body can be an elongated body with two extreme opposing ends or an L-shaped body with two ends and an elbow in between, for reducing the space occupied.

The voltage sensor is embedded in the body and extending along the body between the first and second end of the body (the sensor is arranged distributed along the shape of the body, i.e. if the body is an elongated shaped body the voltage sensor, and consequently the resistances that constitute the sensor, are placed longitudinally or in a zigzag configuration along the body and if the body is L-shaped then the resistances are arranged along the body following the L shape of the body) such that a first terminal of the sensor is connected to the low voltage terminal and a second terminal of the sensor is connected to the high voltage terminal.

According to the invention the body comprises a flexible material such that, when the plug is coupled to the bushing, the body deforms (with a flexible deformation) to fit (adapt and adjust) to the bushing in an airtight sealing connection and the high voltage terminal of the body contacts with an electrical terminal of the bushing to measure a voltage magnitude of a device of the high voltage equipment connected to the bushing or fixed base. The airtight sealing assures that no gap of air or water is left between the plug and the bushing thus warranting electrical isolation between the plug and the bushing. Besides the flexibility of the body permits to absorb or compensate fabrication tolerances of the plug and bushing and even thermic and mechanical expansion and thus guarantees that the contact between the electrical connector of the voltage sensor remains in electrical contact with the electrical terminal of the bushing despite the working conditions. The high voltage plug of the invention is able to provide a reliable measure of the voltage of the electrical connector that is connected to elements in the high voltage cell.

Since the sensor is embedded in the body, and there is no need for an intermediate connector (T-shaped connector or male-male connector) the plug has more compact dimensions and makes it possible to place the plug (and take a voltage measure) in places where there is a limitation on the space available.

The structure of the plug having the sensor embedded in the body also provides for a controlled location of the sensor and therefore a reduction on the influence from external elements to the sensor. Hence, being the sensor embedded in the body, the sensor is physically protected from external aggressions (mechanical or environmental) and the proper functioning of the sensor is also preserved upon being the sensor less prone to interactions with elements external to the sensor which could otherwise alter proper operation of the sensor.

Furthermore, the structure of the plug having the sensor embedded in the body gives the manufacturer total control over the manufacturing and configuration of the plug itself and over the sensor components and their orientation and location. This augmented control reduces the risk of errors due to an inappropriate incorporation of sensor components. In addition, once embedded inside the body, the position of every component of the sensor can be perfectly defined and the risk of errors due to unforeseen displacements is reduced.

According to a preferred embodiment of the invention, the body can be made of a material selected from EPDM, silicone, TPE and combinations thereof. Thus, the body can be made of an elastically deformable material so as to provide a tight fit between the body and the bushing. The tight fit allows for a hermetic, waterproof and/or dustproof adjustment. Different degrees of tightness may be required depending on the specifications for the installation where the high voltage plug is included. The different degrees of protection can be achieved by means of the structure and the material of the body. For instance, the closure of the plug on the bushing can range from waterproof to non-protection against water if such a protection is unnecessary. In other words, the structure and material of the plug allow the plug to meet the working conditions of the electrical equipment where the plug is mounted. Usually, parts that must comply with some sort of these operating conditions bear an IP Code, (International Protection Marking) which classifies and rates the degree of protection provided against intrusion (body parts such as hands and fingers), dust, accidental contact, and water by mechanical casings and electrical enclosures.

According to other features of the invention, the body can comprise a reinforcement material, arranged in the shape of a tube or similar, for example of metal, to obtain some kind of rigidity in the part of the plug where the sensor is placed, especially where the resistors or resistive elements are located, where no elastic deformation is required. This reinforcement material acts as a protective element to prevent the bending and cracking of the resistors or resistive elements.

According to other features of the invention, the body can comprise an external semi-conductive layer.

The high voltage measuring plug of the invention can comprise a low voltage resistance. The low voltage resistance can be embedded in the body and connected between the first terminal and the low voltage terminal. In an alternative embodiment the low voltage resistance can be a separate part connectable to the low voltage terminal through the outside of the body.

Additionally, in a preferred embodiment, the high voltage plug device can comprise a ground connection. This ground connection is a terminal for the connection of a cable for grounding the high voltage plug device so that the high voltage plug device is safe for manipulation of a person having access to the high voltage plug device. As for the location of the ground connection, the ground connection can be placed in different positions of the high voltage plug device. In a first location, the ground connection can be accessible through the first closed end of the body. In a second location, the ground connection can be accessible through a point in a lateral surface of the body.

Regarding the voltage sensor, it can comprise at least one resistor or resistive element. Alternatively the voltage sensor can comprise capacitors.

Externally, the high voltage plug device can be elbow-shaped. This elbow shape is sometimes preferred, especially in cases where there is a constraint in the space available to house the high voltage plug device.

According to preferred embodiments of the invention, the high voltage plug device can be configured to receive a bushing or fixed base selected from a DIN-A, DIN-B and DIN-C. However, as it becomes readily apparent, the high voltage plug device can be configured to receive other typical or even *ad hoc* bushing connector types and it is clearly not restricted to any specific standard or configuration connection.

Advantages and additional features of the invention will become apparent from the following detailed description and will specifically be defined in the claims.

### BRIEF DESCRIPTION OF THE DRAWINGS

To complete the description and in order to aid a better understanding of the characteristics of the invention, according to examples of preferred embodiments thereof, a set of drawings is enclosed forming an integral part of the description where, for purposes of illustration and in a non-limiting sense, the following is shown:
Figure 1 shows voltage sensor plugs according to the state of art.
Figure 2 shows an embodiment of the high voltage plug according to the invention.
Figure 3 shows the high voltage plug of the invention coupled to a bushing of a HV cell.
Figures 4A and 4B show the high voltage plug of the invention comprising a low voltage resistance and a ground connection.

The high voltage plug comprises the following elements:
- 1: High voltage plug device
- 2: Body
- 21: First closed end of the body
- 211: Low voltage terminal of the body
- 22: Second open end of the body
- 222: High voltage terminal of the body
- 23: Housing of the body
- 26: Reinforcement material
- 27: Semi-conductive layer
- 3: Voltage sensor
- 31: First terminal of the sensor
- 32: Second terminal of the sensor
- 4: Bushing or fixed base
- 41: Electrical terminal
- 42: High voltage cell
- 5: Ground connection
- 6: Low voltage resistance

### DESCRIPTION OF A PREFERRED EMBODIMENT OF THE INVENTION

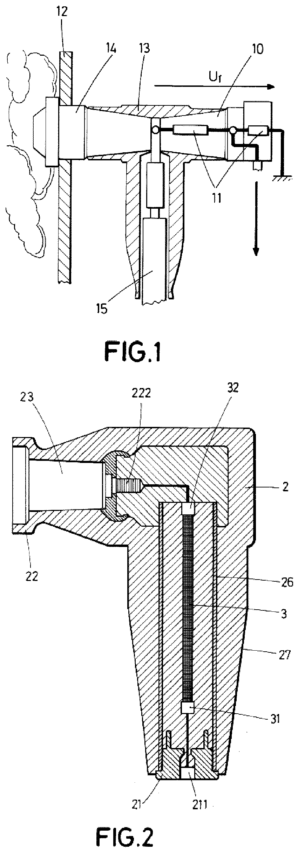

Figure 1 shows a plug device 10 with two resistors 11 for measuring a voltage magnitude according to the state of art. The plug 10 is connected to a HV voltage cell 12 through a T-shaped connector 13 (comprising a HV cable 15) that is coupled to a bushing 14 of the HV cell 12.

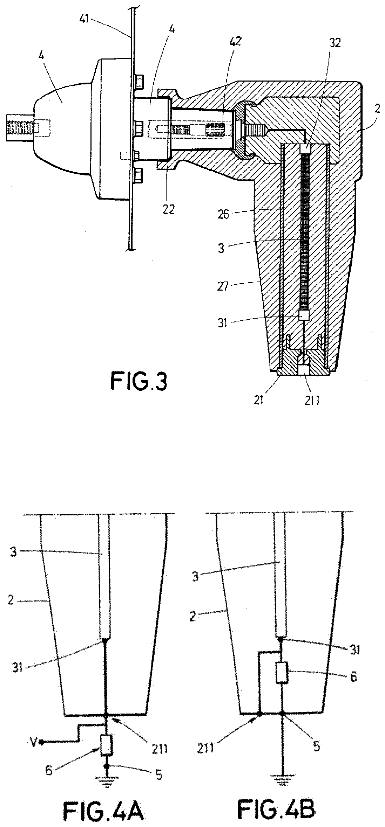

Figure 2 shows an embodiment of the invention where the high voltage plug device 1 comprises a body 2 with a second open end 22 comprising a housing 23. This housing 23 has a conical shape configured to be adapted to the conjugated conical shape of the bushing or fixed base 4 of a HV cell 41 where the high voltage plug device 1 is to be connected. The shape of the housing 23 is configured so that the high voltage plug device 1 can be firmly coupled to the electrical terminal 42 of the bushing 4 in a female-male connection. Figure 3 shows the high voltage plug 1 as a female member coupled to the electrical terminal 42 of a bushing 4 which acts as a male member.

As shown in figures 2 and 3 the voltage sensor 3 is embedded in the body 2. The voltage sensor 3 comprises two electric terminals, a first terminal 31 connected to a low voltage terminal 211 of the body 2 and a second terminal 32 connected to a high voltage terminal 222 of the body 2.

When the high voltage plug device 1 is coupled to the bushing 4 as shown in figure 3 the electrical terminal 42 of the bushing 4 is connected with the high voltage terminal 222 of the body and with the second terminal 32 of the voltage sensor 3 such that the voltage sensor 3 can provide a measure of the voltage of the electrical terminal 42 of the bushing 4 through the low voltage terminal 211 of the body 2 which is connected to the first terminal 31 of the sensor 3.

The embodiment of the voltage sensor 3 illustrated in figures 2 and 3 also shows the voltage sensor 3 consisting in a single resistor or resistive element, but the sensor can be constituted by two or more resistors or resistive elements connected in series. This series arrangement of the resistors or resistive elements allows dividing the voltage applied to each resistor or resistive element. This series arrangement is preferred when each resistor or resistive element cannot bear the voltage of the electrical terminal 222. The voltage sensor 3 can alternatively be constituted by capacitive elements, not represented.

Figures 2 and 3 show an embodiment of the high voltage plug device 1 where the plug is elbow-shaped, but obviously the high voltage plug device 1 can have any suitable configuration as for example cylindrical.

The high voltage plug device 1 can comprise a low voltage resistance 6 as shown in figures 4A and 4B. This low voltage resistance 6 can be embedded in the body 2 and connected between the first terminal 31 and the low voltage terminal 211 as shown in figure 4A or can be a separate part connectable to the low voltage terminal 211 through the outside of the body 2 as shown in figure 4B. The high voltage plug device 1 comprises a ground connection 5. Figures 4A and 4B show an embodiment where the ground connection 5 is accessible through the first closed end 21 of the body 2, but the ground connection 5 can also be accessible through a point in a lateral surface of the body 2.

Figures 2 and 3 also show that the high voltage plug device 1 comprises a reinforcement material 26 in the interior of the high voltage plug device 1, especially extending along a portion surrounding the voltage sensor 3 so as to protect the resistors or resistive elements.

Figures 2 and 3 also show that the high voltage plug device 1 comprises an external semi-conductive layer 27.

In this text, the word "comprise" and its variants (such as "comprising", etc.) should not be interpreted in an excluding manner, that is to say, they do not exclude the possibility that what is described includes other elements, phases, etc.

On the other hand, the invention is not limited to the specific embodiments described, but also includes, for example, the variants that may be carried out by a person skilled in the art (for example, in terms of the selection of materials, dimensions, components, configuration, etc.) from what is derived from the claims.

## Claims

1. High voltage measuring plug device (1) comprising a body (2) and a voltage sensor (3), the body (2) comprising a first closed end (21) comprising a low voltage terminal (211), and a second open end (22) comprising a housing (23) to receive a rigid bushing (4) of a high voltage equipment (41), the second open end (22) comprising a high voltage terminal (222),
and wherein the voltage sensor (3) is embedded in the body (2) and extending along the body (2) between the first closed end (21) and second open end (22) of the body (2) such that a first terminal (31) of the sensor (3) is connected to the low voltage terminal (211) and a second terminal (32) of the sensor (3) is connected to the high voltage terminal (222),
the body (2) comprising a flexible material such that, when the plug (1) is coupled to the bushing (4), the body (2) deforms to fit to the bushing (4) in an airtight sealing connection and the high voltage terminal (222) of the body (2) contacts with an electrical terminal (42) of the bushing (4) to measure a voltage magnitude of a device of the high voltage equipment connected to the bushing (4),

2. High voltage measuring plug device (1) as in claim 1, wherein the body (2) is made of a material selected from EPDM, silicone, TPE and combinations thereof.

3. High voltage measuring plug device (1) as in claim 2, wherein the body (2) comprises a reinforcement material (26).

4. High voltage measuring plug device (1) as in any of previous claims wherein the body (2) comprises an external semi-conductive layer (27).

5. High voltage measuring plug device (1) as in any of previous claims comprising a low voltage resistance (6).

6. High voltage measuring plug device (1) as in claim 5 wherein the low voltage resistance (6) is embedded in the body (2) and connected between the first terminal (31) and the low voltage terminal (211).

7. High voltage measuring plug device (1) as in claim 5 wherein the low voltage resistance (6) is a separate part connectable to the low voltage terminal (211) through the outside of the body (2).

8. High voltage measuring plug device (1) as in any of previous claims comprising a ground connection (5).

9. High voltage measuring plug device (1) as in claim 8 wherein the ground connection (5) is accessible through the first closed end (21) of the body (2).

10. High voltage measuring plug device (1) as in claim 8 wherein the ground connection (5) is accessible through a point in a lateral surface of the body (2).

11. High voltage measuring plug device (1) as in any of previous claims wherein the voltage sensor (3) comprises at least one resistor (33).

12. High voltage measuring plug device (1) as in any of previous claims wherein the inner housing (23) has a conical shape.

13. High voltage measuring plug device (1) as in any of previous claims wherein the body (2) is elbow-shaped.

14. High voltage measuring plug device (1) as in any of previous claims configured to receive a bushing (4) selected from a DIN-A, DIN-B and DIN-C.
